# DEMANDE DE BREVET EUROPEEN

(11) **EP 4 167 290 A1**
(43) Date de publication de la demande: **19.04.2023**
(21) Numéro de dépôt: 22201513.3
(22) Date de dépôt: 14.10.2022
(51) Int. Cl.: H01L 29/06, H01L 29/423, H01L 29/66, H01L 27/10, B82Y 10/00

(54) **MATRICE DE BOÎTES QUANTIQUES À QUBITS DE SPIN**

(30) Priorité: 14.10.2021 FR 2110935
(71) Demandeur: Commissariat à l'énergie atomique et aux énergies alternatives, 75015 Paris (FR); Centre national de la recherche scientifique, 75016 Paris (FR)
(72) Inventeur: BERTRAND, Benoit, 38054 GRENOBLE CEDEX 09 (FR); MEUNIER, Tristan, 38000 GRENOBLE (FR); MORTEMOUSQUE, Pierre-André, 38054 GRENOBLE CEDEX 09 (FR)
(74) Mandataire: Cabinet Beaumont

(57) **Abrégé**

La présente description concerne une cellule élémentaire (100) pour une matrice bidimensionnelle (10) de boîtes quantiques, ladite cellule élémentaire s'étendant selon un plan principal (XY) et comprenant :
- une pluralité de sites occupés par des boîtes quantiques (110) aptes à confiner au moins un qubit de spin (150) et comprenant au moins : une première boîte quantique (111), une deuxième boîte quantique (112) adjacente à la première boîte quantique selon une première direction (X) du plan principal (XY) et une troisième boîte quantique (113) adjacente à la première boîte quantique selon une deuxième direction (Y) du plan principal (XY) ; et
- un premier site de blocage (141), préférablement en matériau diélectrique, adjacent aux deuxième et troisième boîtes quantiques (112, 113) dans les directions X et Y, respectivement, vers lequel un qubit de spin ne peut être déplacé. Chaque deuxième et troisième boîte quantique est donc directement adjacent à deux sites de blocage.

## Description

### Domaine technique

La présente description concerne de façon générale le domaine de l'information quantique ou de l'informatique quantique. Elle concerne en particulier les dispositifs quantiques à bits quantiques (appelés "quantum bits" en anglais ou "qubits"), plus précisément des qubits de spin, dans lesquels les qubits sont réalisés dans des boîtes quantiques confinant des charges élémentaires.

### Technique antérieure

Dans le domaine de l'information quantique ou de l'informatique quantique, il est avantageusement recherché d'augmenter l'interconnectivité entre les qubits, notamment pour une meilleure performance d'un processeur quantique, en particulier en vue de l'implémentation de codes de correction d'erreurs quantiques (par exemple le code dit "surface code") .

Les boîtes quantiques peuvent servir d'éléments de base à l'électronique quantique. Les boîtes quantiques utilisent des nanostructures de semiconducteurs pour former des puits de potentiel et confiner des charges élémentaires (électrons ou trous) dans les trois dimensions de l'espace. Les boîtes quantiques visent à isoler un ou plusieurs porteurs de charge pour définir un ou plusieurs qubits. Les qubits sont définis par les états de spin des porteurs de charge confinés dans les boîtes quantiques, d'où le terme de "qubit de spin" qui peut être désigné par le terme "qubit" dans l'ensemble de la présente description. Selon une approche, les porteurs de charge sont confinés par effet de champ sous des grilles de commande des boîtes quantiques.

Lorsque les qubits sont ainsi réalisés dans des boîtes quantiques confinant des charges élémentaires, les boîtes quantiques peuvent former une structure matricielle, en étant agencées de manière à favoriser le couplage entre qubits et permettre notamment d'implémenter des codes de correction d'erreurs quantiques. Une telle matrice de boîtes quantiques peut être linéaire (une seule ligne, s'apparentant à une seule dimension), mais il est avantageux de former une matrice bidimensionnelle afin qu'un qubit ait au moins quatre plus proches voisins, auxquels il est susceptible d'être couplé, au lieu de deux dans une matrice linéaire.

Les boîtes quantiques voisines sont interconnectées les unes aux autres par des barrières tunnel, et chaque boîte quantique possède son propre potentiel chimique. L'interconnectivité entre deux qubits voisins peut être obtenue en contrôlant la barrière tunnel séparant les deux boîtes quantiques correspondantes, voire en agissant sur le potentiel chimique d'une ou des deux boîtes quantiques.

Un problème qui se pose avec une telle matrice de boîtes quantiques concerne l'adressage des qubits qui doit être réalisé dans la structure matricielle pour réaliser les interconnectivités entre qubits. En effet, chacune des boîtes quantiques doit être reliée à une connexion électrique formant un accès électrique à ladite boîte quantique depuis l'extérieur de la matrice, afin notamment de contrôler les barrières tunnel entre deux boîtes quantiques, et éventuellement les potentiels chimiques de boîtes quantiques. Le contrôle de l'interconnectivité entre qubits se fait généralement par l'intermédiaire de grilles de contrôle reliées aux boîtes quantiques, un potentiel électrique de commande pouvant être appliqué sur une grille de contrôle afin de commander un qubit (adressage individuel de qubit) ou plusieurs qubits (adressage parallèle de qubits).

Dans le cas d'un adressage individuel, une grille de contrôle doit pouvoir commander un qubit individuellement. La réalisation des connexions électriques à chacune des boîtes quantiques est complexe et nécessite généralement plusieurs niveaux d'interconnexions électriques, la distance entre les qubits étant généralement trop réduite pour que toutes les connexions électriques reliées aux qubits puissent être sorties dans un même niveau d'interconnexions. Pour des matrices de taille importante, le nombre de niveaux d'interconnexions électriques devient bien trop important pour que cela soit réalisable. Alternativement, les qubits peuvent être espacés, typiquement d'une distance de l'ordre de 10 µm, pour pouvoir intégrer des composants logiques assurant l'adressage individuel des qubits, mais cela nécessite de développer des modules de transfert pour assurer l'interconnectivité entre les qubits malgré la distance qui les sépare. Dans tous les cas, l'adressage des qubits peut être problématique à gérer en raison du nombre important de connexions électriques.

L'adressage parallèle consiste à utiliser une même grille pour contrôler plusieurs barrières tunnel, et éventuellement plusieurs potentiels chimiques, de boîtes quantiques, et ainsi pour contrôler plusieurs qubits. En pratique, l'adressage parallèle est généralement obtenu en formant plusieurs niveaux de grilles sur ou dans la matrice de boîtes quantiques, typiquement un niveau de grilles en lignes et un niveau de grilles en colonnes. Une grille en ligne est adaptée pour contrôler tous les qubits de la ligne ou de part et d'autre de la ligne et une grille en colonne est adaptée pour contrôler tous les qubits de la colonne ou de part et d'autre de la colonne. Ainsi, généralement deux niveaux sont nécessaires.

Cette architecture d'adressage parallèle permet de limiter le nombre de connexions électriques, et ainsi de simplifier le réseau d'interconnexions électriques. Cependant, elle rend difficile l'interconnectivité entre des qubits sélectionnés arbitrairement. En effet, le potentiel électrique appliqué par une grille impacte toute la ligne de qubits ou toute la colonne de qubits, ce qui ne permet pas de sélectionner n'importe quelle paire de qubits ou groupe de qubits afin de les coupler entre eux.

En outre, les qubits subissent un problème de variabilité, à savoir, la variabilité du potentiel électrique qu'il faut appliquer pour abaisser la barrière tunnel, en particulier pour qu'un qubit puisse être déplacé d'une boîte quantique à une autre. Ce potentiel électrique peut en effet varier selon les qubits. En d'autres termes, un même potentiel électrique appliqué par une grille sur une même ligne ou une même colonne peut ne pas avoir le même effet sur les différents qubits de la ligne ou de la colonne. L'architecture d'adressage parallèle décrite ne permet généralement pas de gérer ce problème de variabilité, puisqu'elle ne permet pas de différencier les potentiels électriques entre les qubits d'une même ligne ou d'une même colonne.

Afin de pallier les problèmes d'adressage et de variabilité, une autre architecture de matrice peut comporter un troisième niveau de grilles de contrôle, en diagonale. Un objectif est de pouvoir gérer différemment des boîtes quantiques adjacentes sur une même ligne ou une même colonne, et notamment compenser la variabilité des qubits, ce, en gardant la possibilité d'appliquer un potentiel électrique différent via les grilles de contrôle en diagonale. Cependant, un troisième niveau de grilles de contrôle complexifie la réalisation d'une matrice de boîtes quantiques et de ses connexions électriques. En outre, cette solution ne permet finalement pas de compenser localement la variabilité de manière suffisante, et de réaliser un adressage satisfaisant, notamment de sélectionner des qubits arbitrairement. En effet, une opération sur une sélection de qubits peut venir perturber les qubits qui se trouvent autour (phénomène dit de "crosstalk"), et l'application de potentiel électrique par des grilles en diagonale peut venir accentuer ce phénomène, qui, pour être compensé, nécessite des opérations supplémentaires.

### Résumé de l'invention

Il existe un besoin d'un dispositif quantique sous la forme d'une matrice de boîtes quantiques confinant des charges élémentaires, qui soit apte à réaliser l'interconnectivité entre des qubits sélectionnés arbitrairement dans la matrice, et ce, sans qu'il soit nécessaire de prévoir un adressage individuel, permettant en outre de compenser la variabilité des qubits et de limiter le phénomène de crosstalk mentionné ci-avant.

En particulier, il serait par exemple souhaitable de ne pas complexifier la réalisation d'une telle matrice de boîtes quantiques et notamment de limiter les connexions électriques dans ladite matrice.

Un mode de réalisation pallie tout ou partie des inconvénients des matrices de boîtes quantiques connues.

Un mode de réalisation prévoit une cellule élémentaire pour une matrice bidimensionnelle de boîtes quantiques, ladite cellule élémentaire s'étendant selon un plan principal et comprenant :
- une pluralité de sites occupés par des boîtes quantiques aptes à confiner au moins un qubit de spin et comprenant au moins : une première boîte quantique, une deuxième boîte quantique adjacente à la première boîte quantique selon une première direction du plan principal et une troisième boîte quantique adjacente à la première boîte quantique selon une deuxième direction du plan principal ; et
- un premier site de blocage adjacent aux deuxième et troisième boîtes quantiques, vers lequel un qubit de spin ne peut être déplacé.

Selon un mode de réalisation, les première à troisième boîtes quantiques et le premier site de blocage sont agencés de telle sorte que :
- pour un même signal de commande de déplacement de qubit dans la première direction, le déplacement d'un qubit de spin depuis la première boîte quantique vers la deuxième boîte quantique dans la première direction est permis, alors que le déplacement d'un qubit de spin depuis la troisième boîte quantique dans la première direction est bloqué par le premier site de blocage ; et/ou
- pour un même signal de commande de déplacement de qubit dans la deuxième direction, le déplacement d'un qubit de spin depuis la première boîte quantique vers la troisième boîte quantique dans la deuxième direction est permis alors que le déplacement d'un qubit de spin depuis la deuxième boîte quantique dans la deuxième direction est bloqué par le premier site de blocage.

Selon un mode de réalisation, la cellule élémentaire comprend :
- une première grille de commande s'étendant selon la deuxième direction et sur un premier niveau, ladite première grille de commande étant apte à envoyer un signal de commande de déplacement de qubit dans la première direction en agissant sur la barrière tunnel séparant les première et deuxième boîtes quantiques ;
- une deuxième grille de commande s'étendant selon la première direction et sur un deuxième niveau superposé au premier niveau, ladite deuxième grille de commande étant apte à envoyer un signal de commande de déplacement de qubit dans la deuxième direction en agissant sur la barrière tunnel séparant les première et troisième boîtes quantiques.

Selon un mode de réalisation, la cellule élémentaire comprend en outre :
- une quatrième boîte quantique adjacente à la première boîte quantique selon la première direction à l'opposé de la deuxième boîte quantique ;
- un deuxième site de blocage adjacent aux troisième et quatrième boîtes quantique.

Selon un mode de réalisation, les boîtes quantiques et les sites de blocage sont agencés de telle sorte que :
- pour un même signal de commande de déplacement de qubit dans la première direction, le déplacement d'un qubit de spin depuis la première boîte quantique vers la quatrième boîte quantique dans la première direction est permis alors que le déplacement d'un qubit de spin depuis la troisième boîte quantique dans la première direction est bloqué par les premier et deuxième sites de blocage ; et/ou
- pour un même signal de commande de déplacement de qubit dans la deuxième direction, le déplacement d'un qubit de spin depuis la première boîte quantique vers la troisième boîte quantique dans la deuxième direction est permis alors que le déplacement d'un qubit de spin depuis la quatrième boîte quantique dans la deuxième direction est bloqué par le deuxième site de blocage.

Selon un mode de réalisation, la cellule élémentaire comprend en outre :
- une troisième grille de commande s'étendant sur le premier niveau parallèlement à la première grille de commande, ladite troisième grille de commande étant apte à envoyer un signal de commande de déplacement de qubit dans la première direction en agissant sur la barrière tunnel séparant les première et quatrième boîtes quantiques.

Selon un mode de réalisation, la cellule élémentaire comprend en outre :
- une cinquième boîte quantique adjacente à la première boîte quantique selon la deuxième direction à l'opposé de la troisième boîte quantique ;
- un troisième site de blocage adjacent aux deuxième et cinquième boîtes quantiques et un quatrième site de blocage adjacent aux quatrième et cinquième boîtes quantiques.

Selon un mode de réalisation, les boîtes quantiques et les sites de blocage sont agencés de telle sorte que :
- pour un même signal de commande de déplacement de qubit dans la première direction, le déplacement d'un qubit de spin depuis la première boîte quantique vers la quatrième boîte quantique dans la première direction est permis alors que le déplacement d'un qubit de spin depuis la cinquième boîte quantique dans la première direction est bloqué par les troisième et quatrième sites de blocage ; et/ou
- pour un même signal de commande de déplacement de qubit dans la deuxième direction, le déplacement d'un qubit depuis la première boîte quantique vers la cinquième boîte quantique dans la deuxième direction est permis alors que le déplacement d'un qubit de spin depuis la quatrième boîte quantique dans la deuxième direction est bloqué par les deuxième et quatrième sites de blocage.

Selon un mode de réalisation, la cellule élémentaire comprend en outre :
- une quatrième grille de commande s'étendant sur le deuxième niveau parallèlement à la deuxième grille de commande, ladite quatrième grille de commande étant apte à envoyer un signal de commande de déplacement de qubit dans la deuxième direction en agissant sur la barrière tunnel séparant les première et cinquième boîtes quantiques.

Un mode de réalisation prévoit une matrice de boîtes quantiques comprenant au moins deux cellules élémentaires selon un mode de réalisation, les au moins deux cellules élémentaires étant disposées les unes à côté des autres selon la première direction et/ou la deuxième direction, la matrice comportant ainsi une pluralité de premières, deuxièmes, troisièmes boîtes quantiques et de premiers sites de blocage.

Selon un mode de réalisation particulier, les au moins deux cellules élémentaires sont disposées directement les unes à côté des autres selon la première direction et/ou la deuxième direction. Par "directement", il faut comprendre sans boîte quantique intermédiaire.

Selon un mode de réalisation, la matrice comprend au moins autant de sites de blocages que de cellules élémentaires.

Selon un mode de réalisation, les cellules élémentaires adjacentes selon la deuxième direction partagent la même première grille de commande et les cellules élémentaires adjacentes selon la première direction partagent la même deuxième grille de commande.

Selon un mode de réalisation, la matrice comprend :
- entre deux cellules élémentaires adjacentes selon la première direction, une cinquième grille de commande s'étendant sur le premier niveau parallèlement à la première grille de commande ; et/ou
- entre deux cellules élémentaires adjacentes selon la deuxième direction, une sixième grille de commande s'étendant sur le deuxième niveau parallèlement à la deuxième grille de commande.

Selon un mode de réalisation, la matrice comprend une pluralité de cellules élémentaires selon un mode de réalisation dans lequel chaque cellule élémentaire comporte des première, deuxième, troisième, quatrième et cinquième boîtes quantiques et des premier, deuxième, troisième et quatrième sites de blocage, les cellules étant assemblées les unes à côté des autres selon la première direction et/ou la deuxième direction, la matrice comportant ainsi une pluralité de premières, deuxièmes, troisièmes, quatrièmes et cinquièmes boîtes quantiques et de premiers, deuxièmes, troisièmes et quatrièmes sites de blocage.

Selon un mode de réalisation, les cellules élémentaires adjacentes selon la deuxième direction partagent les mêmes première et troisième grilles de commande et les cellules élémentaires adjacentes selon la première direction partagent les mêmes deuxième et quatrième grilles de commande.

Selon un mode de réalisation, la deuxième direction est perpendiculaire à la première direction.

Un mode de réalisation prévoit un dispositif quantique sous la forme d'une matrice dimensionnelle de boîtes quantiques, la matrice comprenant au moins deux cellules élémentaires s'étendant selon un plan principal et disposées les unes à côté des autres selon une première direction du plan principal et/ou une deuxième direction du plan principal, chaque cellule élémentaire comprenant :
- une pluralité de sites occupés par des boîtes quantiques aptes à confiner au moins un qubit de spin et comprenant au moins : une première boîte quantique, une deuxième boîte quantique adjacente à la première boîte quantique selon la première direction du plan principal et une troisième boîte quantique adjacente à la première boîte quantique selon la deuxième direction du plan principal ; et
- au moins un site de blocage ne pouvant confiner aucun qubit de spin, dont un premier site de blocage adjacent aux deuxième et troisième boîtes quantiques ;
la matrice comportant ainsi une pluralité de premières, deuxièmes et troisièmes boîtes quantiques et de sites de blocage agencés pour que tout ou partie des deuxièmes boîtes quantiques soient disposées entre au moins deux sites de blocage dans la deuxième direction, et tout ou partie des troisièmes boîtes quantiques soient disposées entre au moins deux sites de blocage dans la première direction.

De préférence, les cellules élémentaires sont toutes identiques, de sorte que la matrice correspond à un agencement de plusieurs cellules élémentaires identiques selon une première direction et/ou une deuxième direction.

Le positionnement des deuxièmes boîtes quantiques entre au moins deux sites de blocage dans la deuxième direction permet d'autoriser le déplacement d'un qubit de spin depuis et vers ladite deuxième boîte quantique uniquement dans la première direction. Le positionnement des troisièmes boîtes quantiques entre au moins deux sites de blocage dans la première direction permet d'autoriser le déplacement des qubits de spin depuis et vers cette troisième boîte quantique uniquement dans la deuxième direction.

Selon un mode de réalisation, pour chaque cellule élémentaire :
- les boîtes quantiques comprennent en outre une quatrième boîte quantique adjacente à la première boîte quantique selon la première direction à l'opposé de la deuxième boîte quantique ;
- le au moins un site de blocage comprend en outre un deuxième site de blocage adjacent aux troisième et quatrième boîtes quantiques ;
la matrice comportant ainsi également une pluralité de quatrièmes boîtes quantiques, les boîtes quantiques et les sites de blocage étant agencés pour que tout ou partie des quatrièmes boîtes quantiques soient disposées entre au moins deux sites de blocage dans la deuxième direction.

Le positionnement des quatrièmes boîtes quantiques entre au moins deux sites de blocage dans la deuxième direction permet d'autoriser le déplacement d'un qubit de spin depuis et vers ladite quatrième boîte quantique uniquement dans la première direction.

Selon un mode de réalisation, pour chaque cellule élémentaire :
- les boîtes quantiques comprennent en outre une cinquième boîte quantique adjacente à la première boîte quantique selon la deuxième direction à l'opposé de la troisième boîte quantique ;
- le au moins un site de blocage comprend en outre un troisième site de blocage adjacent aux deuxième et cinquième boîtes quantiques et un quatrième site de blocage adjacent aux quatrième et cinquième boîtes quantiques ;
la matrice comportant ainsi également une pluralité de cinquièmes boîtes quantiques, les boîtes quantiques et les sites de blocage étant agencés pour que tout ou partie des deuxièmes boîtes quantiques soient disposées entre au moins quatre sites de blocage dans la deuxième direction, tout ou partie des troisièmes boîtes quantiques soient disposées entre au moins quatre sites de blocage dans la première direction, tout ou partie des quatrièmes boîtes quantiques soient disposées entre au moins quatre sites de blocage dans la deuxième direction, et tout ou partie des cinquièmes boîtes quantiques soient disposées entre au moins quatre sites de blocage dans la première direction.

Le positionnement des cinquièmes boîtes quantiques entre au moins quatre sites de blocage dans la première direction permet d'autoriser le déplacement d'un qubit de spin depuis et vers ladite cinquième boîte quantique uniquement dans la deuxième direction.

De préférence, la matrice comprend au moins trois cellules élémentaires, et les cellules élémentaires sont disposées les unes à côté des autres selon la première direction et selon la deuxième direction.

Selon un mode de réalisation, chaque boîte quantique est une nanostructure en semiconducteur, et chaque site de blocage est une nanostructure au moins partiellement exempte de semiconducteur, par exemple comprenant un matériau diélectrique.

Selon un mode de réalisation particulier, chaque site de blocage est une nanostructure majoritairement exempte de semiconducteur, par exemple comprenant un matériau diélectrique.

Selon un mode de réalisation, les bords de chaque boîte quantique sont reliés à une grille de commande.

Selon un mode de réalisation, les barrières tunnel entre deux boîtes quantiques sont toutes reliées à une grille de commande.

De préférence, les barrières tunnel d'une même ligne (selon la première direction) sont commandées par une même grille de commande, et les barrières tunnel d'une même colonne (selon la deuxième direction) sont commandées par une même grille de commande. Ainsi, les barrières tunnel entre deux boîtes quantiques ne sont pas contrôlées individuellement, mais elles sont contrôlées en ligne(s) et en colonne(s).

Selon un mode de réalisation, les bords de certains parmi les sites de blocage, par exemple des sites de blocage sur les bords de la matrice, ne sont pas tous reliés à une grille de commande.

Un mode de réalisation prévoit un procédé de déplacement de qubits dans une matrice de boîtes quantiques, par exemple d'un dispositif quantique selon un mode de réalisation, le procédé de déplacement comprenant :
- une étape d'application d'un signal de déplacement de qubit dans la première direction, ledit signal étant appliqué à un alignement, selon la deuxième direction, de boîtes quantiques comprenant au moins des première et troisième boîtes quantiques, le signal de déplacement permettant le déplacement d'un qubit dans la première direction depuis la première boîte quantique vers une deuxième boîte quantique adjacente à la première boîte quantique, alors que le déplacement d'un qubit depuis la troisième boîte quantique dans la première direction est bloqué par un site de blocage.

Selon un mode de réalisation, le procédé comprend en outre, préalablement à l'étape d'application du signal de déplacement, une étape de déplacement dans la deuxième direction d'au moins un qubit depuis une première boîte quantique vers une troisième boîte quantique adjacente à ladite première boîte quantique de manière à bloquer le déplacement dans la première direction dudit qubit par le site de blocage.

Un mode de réalisation prévoit un procédé de fabrication d'une matrice de boîtes quantiques, par exemple d'un dispositif quantique selon un mode de réalisation, ledit procédé de fabrication comprenant les étapes suivantes :
- une étape de fourniture d'un substrat ayant au moins une couche supérieure en matériau semiconducteur ;
- une étape de formation de sites de blocage et de boîtes quantiques, ladite étape de formation comprenant la suppression du matériau semiconducteur dans des premières zones de la couche supérieure de semiconducteur afin de former une pluralité de sites de blocage, des deuxièmes zones de la couche supérieure de semiconducteur dans lesquelles le matériau semiconducteur n'est pas supprimé formant une pluralité de premières, deuxièmes et troisièmes boîtes quantiques ; ladite étape de formation étant réalisée de telle sorte que chaque deuxième boîte quantique soit adjacente à une première boîte quantique selon une première direction du plan principal, que chaque troisième boîte quantique soit adjacente à une première boîte quantique selon une deuxième direction du plan principal et que chaque site de blocage soit adjacent à une deuxième boîte quantique et une troisième boîte quantique.

Selon un mode de réalisation, le substrat comprend en outre une couche inférieure en matériau diélectrique disposée sous la couche supérieure.

Selon un mode de réalisation particulier, la suppression du matériau semiconducteur dans les premières zones de la couche supérieure de semiconducteur est adaptée à révéler le matériau diélectrique de la couche inférieure.

Selon un mode de réalisation, la suppression du matériau semiconducteur comprend :
- une étape de photolithographie apte à former sur la couche supérieure de semiconducteur un motif en photorésine et des trous au sein du motif ; et
- une étape de gravure de la couche supérieure de semiconducteur dans les trous de manière à former les sites de blocage.

Selon un mode de réalisation particulier, l'étape de gravure de la couche supérieure de semiconducteur dans les trous est réalisée jusqu'à la couche inférieure de diélectrique.

Selon un mode de réalisation, le procédé de fabrication comprend en outre :
- une étape de formation d'un premier niveau de grilles de commande s'étendant parallèlement les unes aux autres dans la deuxième direction ; et
- une étape de formation d'un deuxième niveau de grilles de commande s'étendant parallèlement les unes aux autres dans la première direction.

Selon un mode de réalisation particulier, chaque étape de formation du premier et du deuxième niveau de grilles de commande comprend une étape de dépôt d'une couche en matériau conducteur, suivie d'une étape de photolithographie puis d'une étape de gravure.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente une matrice de boîtes quantiques ;
la figure 2A représente une vue de dessus d'une cellule élémentaire d'une matrice de boîtes quantiques selon un mode de réalisation ;
la figure 2B représente une vue de dessus d'une matrice de boîtes quantiques comprenant plusieurs cellules élémentaires de la figure 2A ;
la figure 3A représente une vue de dessus d'une cellule élémentaire d'une matrice de boîtes quantiques selon un autre mode de réalisation ;
la figure 3B représente une vue de dessus d'une matrice de boîtes quantiques comprenant plusieurs cellules élémentaires de la figure 3A ;
la figure 4A, la figure 4B, la figure 4C, la figure 4D, la figure 4E, la figure 4F, la figure 4G et la figure 4H représentent des exemples de procédés de déplacement de qubits au sein d'une matrice de boîtes quantiques selon un mode de réalisation ;
la figure 5A, la figure 5B, la figure 5C, la figure 5D, la figure 5E, la figure 5F, la figure 5G, la figure 5H et la figure 5I représentent un exemple de procédé de fabrication d'une matrice de boîtes quantiques selon un mode de réalisation ;
la figure 6A et la figure 6B représentent deux variantes d'un procédé de fabrication d'une matrice de boîtes quantiques selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la structure d'une boîte quantique apte à confiner un qubit de spin n'a pas été détaillée. Une telle boîte quantique peut être réalisée en utilisant la technologie des transistors à effet de champ (FET), et notamment avec une technologie dérivée de celle des dispositifs CMOS, ou par d'autres technologies.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à une matrice de boîtes quantiques dans une position normale d'utilisation.

Sauf précision contraire, les expressions "environ", "approximativement", "sensiblement", et "de l'ordre de" signifient à 10 % près, de préférence à 5 % près.

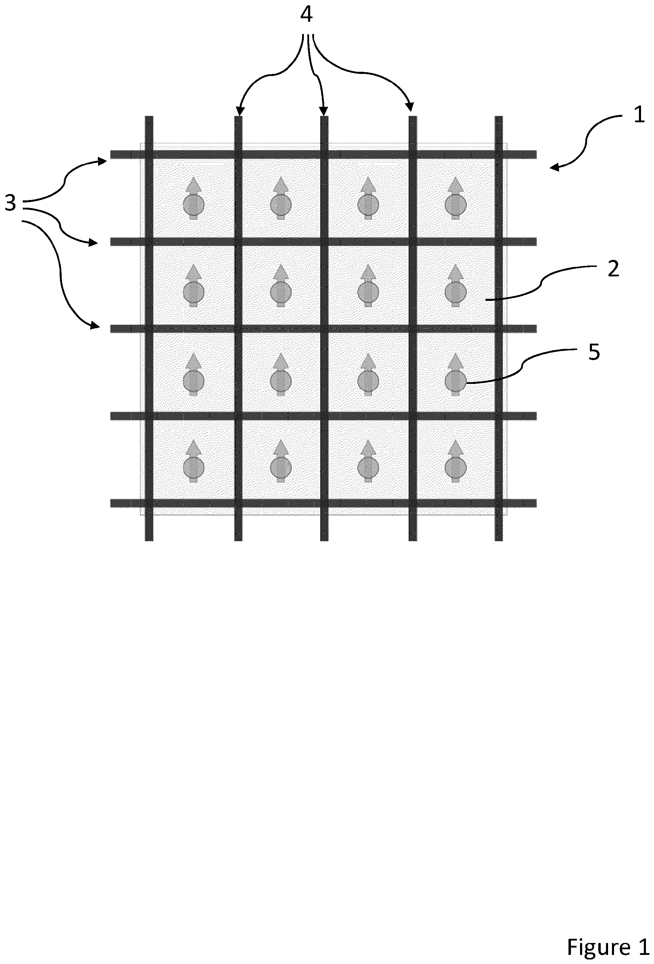

La figure 1 représente une matrice bidimensionnelle 1 de boîtes quantiques 2. Chaque boîte quantique 2 contient un qubit 5. La matrice formée est ainsi une matrice dense de qubits. Le couplage entre un qubit central est possible avec au moins ses quatre plus proches qubits voisins, notamment en agissant sur la barrière tunnel entre les boîtes quantiques correspondantes. Plus précisément, un niveau de grilles en lignes 3 et un niveau de grilles en colonnes 4 permettent d'appliquer un potentiel électrique de commande à plusieurs boîtes quantiques afin de pouvoir réaliser un adressage parallèle de qubits. Une grille en ligne 3 est adaptée pour contrôler les qubits situés de part et d'autre de la ligne et une grille en colonne 4 est adaptée pour contrôler les qubits situés de part et d'autre de la colonne. Ainsi, si l'opération sur une ligne complète ou sur une colonne complète est envisageable, une opération locale sur un qubit unique ou deux qubits donnés devient complexe, voire impossible. En outre, une telle structure matricielle dense ne permet pas de compenser localement la variabilité des qubits.

Les inventeurs proposent des matrices de boîtes quantiques améliorées, selon des modes de réalisation, permettant de pallier tout ou partie des inconvénients précités.

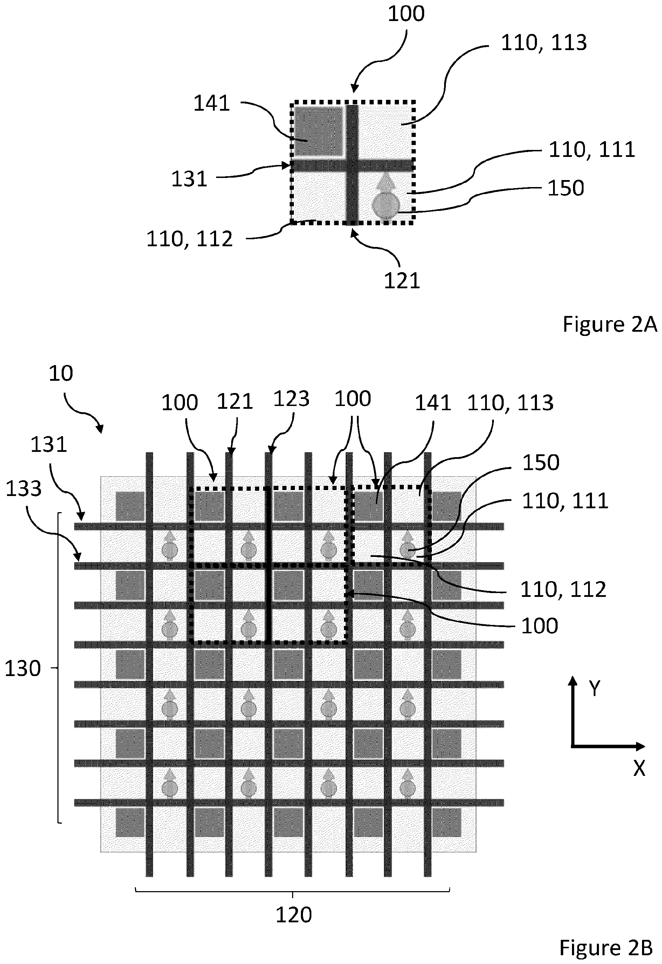

Les figures 2A et 2B représentent respectivement une cellule élémentaire 100 selon un mode de réalisation et une matrice bidimensionnelle 10 comprenant plusieurs cellules élémentaires 100.

La cellule élémentaire 100 présente en vue de dessus (plan principal XY) une forme sensiblement carrée comprenant quatre sites. Trois des sites sont occupés par des boîtes quantiques 110 et un quatrième site est un premier site de blocage 141 des qubits.

Un site de blocage est défini comme étant un site configuré pour bloquer/interdire le déplacement de tout qubit de spin vers et à l'intérieur dudit site. En d'autres termes, un site de blocage est un site qui ne peut confiner un qubit de spin. Un site de blocage peut être réalisé par exemple en gravant au fond de zones définies dans la matrice la couche de semiconducteur dans laquelle les boîtes quantiques sont formées.

Chaque boîte quantique 110 est apte à confiner au moins un qubit de spin 150, deux boîtes quantiques adjacentes étant séparées par une barrière tunnel de sorte qu'un qubit de spin 150 puisse être confiné dans une des deux boîtes quantiques et/ou se déplacer entre les deux boîtes quantiques par effet tunnel.

Les boîtes quantiques comprennent :
- une première boîte quantique 111 ;
- une deuxième boîte quantique 112 adjacente à la première boîte quantique selon une première direction X du plan principal XY ; et
- une troisième boîte quantique 113 adjacente à la première boîte quantique dans une deuxième direction Y du plan principal XY.

La cellule élémentaire 100 représentée comprend en outre :
- une première grille de commande 121 s'étendant selon la deuxième direction Y (en colonne) et sur un premier niveau 120, ladite première grille de commande étant apte à envoyer un signal de commande de déplacement de qubit dans la première direction X en agissant sur la barrière tunnel séparant les première et deuxième boîtes quantiques 111, 112 ; et
- une deuxième grille de commande 131 s'étendant selon la première direction X (en ligne) et sur un deuxième niveau 130 superposé au premier niveau 120, ladite deuxième grille de commande étant apte à envoyer un signal de commande de déplacement de qubit dans la deuxième direction Y en agissant sur la barrière tunnel séparant les première et troisième boîtes quantiques 111, 113.

Les boîtes quantiques 111, 112, 113 et le premier site de blocage 141 sont agencés de telle sorte que :
- lorsque la première grille 121 sort un signal de commande de déplacement de qubit dans la première direction X, un qubit 150 confiné dans la première boîte quantique 111 peut être déplacé vers la deuxième boîte quantique 112, alors qu'un qubit confiné dans la troisième boîte quantique 113 ne peut se déplacer dans la première direction X puisque le premier site de blocage 141 bloque le déplacement de qubits dans cette direction ; et
- lorsque la deuxième grille 131 sort un signal de commande de déplacement de qubit dans la deuxième direction Y, un qubit 150 confiné dans la première boîte quantique 111 peut être déplacé vers la troisième boîte quantique 113, alors qu'un qubit confiné dans la deuxième boîte quantique 112 ne peut se déplacer dans la deuxième direction Y puisque le premier site de blocage 141 bloque le déplacement de qubits dans cette direction.

Le premier site de blocage 141 est représenté en diagonale de la première boîte quantique 111, la deuxième boîte quantique 112 est disposée en dessous du premier site de blocage 141 dans la deuxième direction Y et la troisième boîte quantique 113 est disposée à droite du premier site de blocage 141 dans la première direction X, mais d'autres configurations sont possibles. Par exemple, la deuxième boîte quantique 112 peut être disposée au-dessus du premier site de blocage 141 et/ou la troisième boîte quantique 113 peut être disposée à gauche du premier site de blocage 141.

La figure 2B représente une matrice 10 de boîtes quantiques 110, la matrice étant formée par une pluralité de mêmes cellules élémentaires 100 adjacentes les unes aux autres dans la première direction X et dans la deuxième direction Y.

Dans la matrice 10 ainsi formée, les deuxièmes et troisièmes boîtes quantiques 112, 113 de la pluralité de cellules élémentaires 100 se retrouvent entre deux premiers sites de blocage 141 dans une ou l'autre des deux directions X, Y (sauf certaines deuxièmes et troisièmes boîtes quantiques se situant dans les bords de la matrice).

Les deuxièmes et troisièmes boîtes quantiques peuvent être désignées comme étant des boîtes de stockage. Un qubit placé (stocké) dans une boîte de stockage devient insensible à l'ensemble ou à une partie des signaux d'une même ligne ou d'une même colonne de commande (envoyés via la grille de commande correspondante).

Afin de rendre un (des) qubit(s) insensible(s) à l'ensemble ou à une partie des signaux d'une même ligne (respectivement d'une même colonne de commande), l'invention permet de déplacer ce(s) qubit(s) dans une (des) boîte(s) de stockage astucieusement choisie(s) afin de permettre la désélection de ce(s) qubit(s) préalablement à une opération sur une ligne (respectivement sur une colonne) de la matrice. En d'autres termes, pour adresser une partie seulement des qubits d'une ligne (respectivement d'une colonne), certains qubits de ladite ligne sont préalablement désélectionnés en les déplaçant vers une colonne voisine (respectivement vers une ligne voisine) dans une boîte quantique de stockage où leur déplacement n'est plus permis dans la direction de la ligne (respectivement de la colonne).

Les cellules élémentaires adjacentes selon la deuxième direction Y partagent la même première grille de commande 121 et les cellules élémentaires adjacentes selon la première direction X partagent la même deuxième grille de commande 131.

En outre, la matrice 10 comprend, entre deux cellules adjacentes selon la première direction X, une grille complémentaire de commande 123 (également désignée cinquième grille de commande) parallèle à la première grille de commande 121 et, entre deux cellules adjacentes selon la deuxième direction Y, une grille complémentaire de commande 133 (également désignée sixième grille de commande) parallèle à la deuxième grille de commande 131.

La matrice 10 représentée comprend ainsi :
- un premier niveau 120 de grilles de commande 121, 123 s'étendant parallèlement les unes aux autres selon la deuxième direction Y, formant ainsi des colonnes de grilles ; chaque grille en colonne est apte à commander le déplacement de qubits de spin 150 entre deux boîtes quantiques adjacentes disposées de part et d'autre de ladite grille ; et
- un deuxième niveau 130 de grilles de commande 131, 133 s'étendant parallèlement les unes aux autres selon la première direction X formant ainsi des lignes de grilles ; le deuxième niveau 130 est superposé au premier niveau 120 ; chaque grille en ligne est apte à commander le déplacement de qubits de spin 150 entre deux boîtes quantiques adjacentes disposées de part et d'autre de ladite grille.

Ainsi, la matrice 10 est obtenue par l'agencement de plusieurs cellules élémentaires 100 les unes à côté des autres dans les deux directions X et Y, et les boîtes quantiques adjacentes dans chacune des deux directions sont disposées de part et d'autre d'une même grille de commande de manière à pouvoir commander les barrières tunnel entre lesdites boîtes quantiques et, ce faisant, les déplacements de qubits entre lesdites boîtes quantiques. En d'autres termes, les barrières tunnel d'une même ligne sont commandées par une même grille de commande, et les barrières tunnel d'une même colonne sont commandées par une même grille de commande.

En outre, le positionnement astucieux de sites de blocage vis-à-vis des boîtes quantiques, et notamment des boîtes quantiques de stockage, permet, suite à une commande de déplacement en ligne ou en colonne, d'autoriser ou de bloquer le déplacement d'un (ou de plusieurs) qubit(s) dans une ou l'autre des deux directions, selon le positionnement du (des) qubit(s) avant la commande.

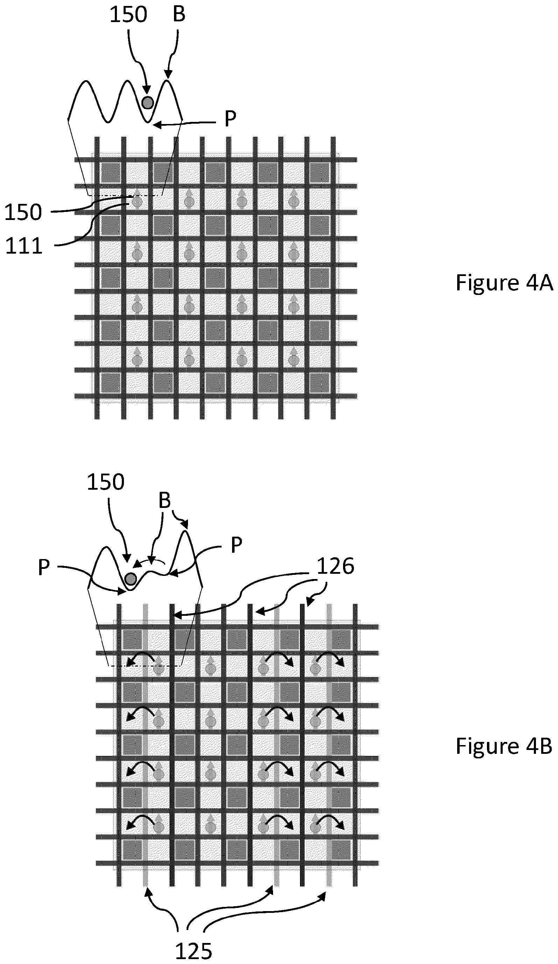

Comme cela sera expliqué en lien avec les figures 4A à 4H, cela permet de faire des opérations sur certains qubits sélectionnés arbitrairement dans la matrice, et ce, malgré le choix d'un adressage parallèle en ligne et en colonne. En outre, le mode de réalisation de la figure 2B permet de limiter le nombre de déplacements à effectuer sur les qubits. De plus, cela permet de réaliser de telles opérations sans toutefois complexifier le réseau d'interconnexion des qubits, puisqu'il n'est notamment pas nécessaire de rajouter un niveau de grilles de commande.

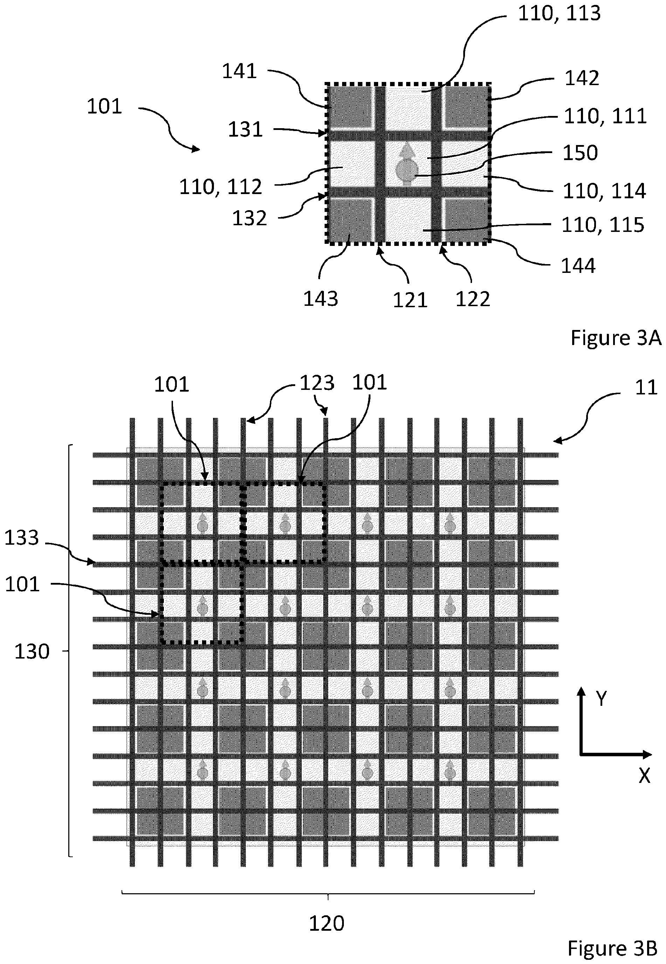

Les figures 3A et 3B représentent respectivement une cellule élémentaire 101 selon un autre mode de réalisation et une matrice bidimensionnelle 11 comprenant plusieurs cellules élémentaires 101.

Comme pour la cellule élémentaire 100 de la figure 2A, la cellule élémentaire 101 de la figure 3A présente en vue de dessus (plan principal XY) une forme sensiblement carrée, mais elle s'en différencie en ce qu'elle comprend neuf sites, cinq de des sites étant occupés par des boîtes quantiques 110 et quatre de ces sites étant des sites de blocage des qubits. Les première, deuxième, troisième boîtes quantiques 111, 112, 113 et le premier site de blocage 141 de la cellule élémentaire 101 de la figure 3A sont agencés comme pour la cellule élémentaire 100 de la figure 2A.

En plus des boîtes quantiques de la cellule élémentaire 100 de la figure 2A, la cellule élémentaire 101 de la figure 3A comprend :
- une quatrième boîte quantique 114 adjacente à la première boîte quantique selon la première direction X et à l'opposé de la deuxième boîte quantique 112 ; et
- une cinquième boîte quantique 115 adjacente à la première boîte quantique dans la deuxième direction Y et à l'opposé de la troisième boîte quantique 113.

En plus du premier site de blocage 141 de la cellule élémentaire 100 de la figure 2A, la cellule élémentaire 101 de la figure 3A comprend :
- un deuxième site de blocage 142 ;
- un troisième site de blocage 143 ; et
- un quatrième site de blocage 144.

Les boîtes quantiques et les sites de blocage sont agencés de telle manière que les deuxième à cinquième boîtes quantiques soient entre deux sites de blocage. Plus précisément dans l'exemple représenté :
- la deuxième boîte quantique 112 est entre les premier et troisième sites de blocage 141, 143 ;
- la troisième boîte quantique 113 est entre les premier et deuxième sites de blocage 141, 142 ;
- la quatrième boîte quantique 114 est entre les deuxième et quatrième sites de blocage 142, 144 ; et
- la cinquième boîte quantique 115 est entre les troisième et quatrième sites de blocage 143, 144.

Les sites de blocage sont représentés en diagonale de la première boîte quantique 111.

En plus des première et deuxième grilles de commandes de la cellule élémentaire 100 de la figure 2A, la cellule élémentaire 101 de la figure 3A comprend :
- une troisième grille de commande 122 parallèle à la première grille de commande 121 (en colonne) sur le premier niveau 120, ladite troisième grille de commande étant apte à envoyer un signal de commande de déplacement de qubit dans la première direction X en agissant sur la barrière tunnel séparant les première et quatrième boîtes quantiques 111, 114 ; et
- une quatrième grille de commande 132 parallèle à la deuxième grille de commande 131 (en ligne) sur le deuxième niveau 130, ladite quatrième grille de commande étant apte à envoyer un signal de commande de déplacement de qubit dans la deuxième direction Y en agissant sur la barrière tunnel séparant les première et cinquième boîtes quantiques 111, 115.

En plus de l'agencement déjà défini pour la cellule élémentaire 100 de la figure 2A, les boîtes quantiques et les sites de blocage de la cellule élémentaire 101 de la figure 3A sont agencés de telle sorte que :
- lorsque la troisième grille 122 sort un signal de commande de déplacement de qubit dans la première direction X, un qubit confiné dans la première boîte quantique 111 peut être déplacé vers la quatrième boîte quantique 114 alors qu'un qubit confiné dans la cinquième boîte quantique 115 ne peut se déplacer dans la première direction X puisque les troisième et quatrième sites de blocage 143, 144 bloquent le déplacement de qubits dans cette direction ; et
- lorsque la quatrième grille 132 sort un signal de commande de déplacement de qubit dans la deuxième direction Y, un qubit confiné dans la première boîte quantique 111 peut être déplacé vers la cinquième boîte quantique 115 alors qu'un qubit confiné dans la quatrième boîte quantique 114 ne peut se déplacer dans la deuxième direction Y puisque les deuxième et quatrième sites de blocage 142, 144 bloquent le déplacement de qubits dans cette direction.

La figure 3B représente une matrice 11 de boîtes quantiques 110, la matrice étant formée par une pluralité de mêmes cellules élémentaires 101 adjacentes les unes aux autres dans la première direction X et dans la deuxième direction Y.

Les cellules élémentaires adjacentes selon la deuxième direction Y partagent les mêmes première et troisième grilles de commande 121, 122 et les cellules élémentaires adjacentes selon la première direction X partagent les mêmes deuxième et quatrième grilles de commande 131, 132.

En outre, la matrice 11 comprend, entre deux cellules adjacentes selon la première direction X, une grille complémentaire de commande 123 (également désignée cinquième grille de commande) parallèle à la première grille de commande 121 et, entre deux cellules adjacentes selon la deuxième direction Y, une grille complémentaire de commande 133 (également désignée sixième grille de commande) parallèle à la deuxième grille de commande 131.

La matrice 11 représentée comprend ainsi :
- un premier niveau 120 de grilles de commande 121, 122, 123 s'étendant parallèlement les unes aux autres selon la deuxième direction Y, formant ainsi des grilles en colonnes ; chaque grille en colonne est apte à commander le déplacement de qubits de spin 150 entre deux boîtes quantiques adjacentes disposées de part et d'autre de ladite grille ;
- un deuxième niveau 130 de grilles de commande 131, 132, 133 s'étendant parallèlement les unes aux autres selon la première direction X formant ainsi des grilles en lignes ; le deuxième niveau 130 est superposé au premier niveau 120 ; chaque grille en ligne est apte à commander le déplacement de qubits de spin 150 entre deux boîtes quantiques adjacentes disposées de part et d'autre de ladite grille.

En d'autres termes, les barrières tunnel d'une même ligne sont commandées par une même grille de commande, et les barrières tunnel d'une même colonne sont commandées par une même grille de commande.

Les deuxièmes à cinquièmes boîtes quantiques de la pluralité de cellules élémentaires 101 peuvent être désignées comme étant des boîtes de stockage. Comme expliqué pour la matrice de la figure 2B, un qubit placé dans une telle boîte de stockage devient insensible à l'ensemble ou à une partie des signaux d'une même ligne ou d'une même colonne de commande (envoyés via la grille de commande correspondante) . Afin de rendre un (des) qubit(s) insensible(s) à l'ensemble ou à une partie des signaux d'une même ligne (respectivement d'une même colonne) de commande, l'invention permet de déplacer ce (s) qubit(s) dans une (des) boîte(s) de stockage astucieusement choisie(s) afin de permettre la désélection de ce (s) qubit (s) préalablement à une opération sur une ligne (respectivement une colonne) de la matrice. En d'autres termes, pour adresser une partie seulement des qubits d'une ligne (respectivement d'une colonne), certains qubits sont préalablement désélectionnés en les déplaçant vers une colonne voisine (respectivement vers une ligne voisine) dans une boîte quantique de stockage où leur déplacement n'est plus permis dans la direction de la ligne (respectivement de la colonne). Cela permet de faire des opérations sur certains qubits sélectionnés arbitrairement dans la matrice, et ce, malgré le choix d'un adressage parallèle en ligne et en colonne. En outre, cela permet de réaliser de telles opérations sans toutefois complexifier le réseau d'interconnexion des qubits, puisqu'il n'est notamment pas nécessaire de rajouter un niveau de grilles de commande.

La matrice 11 obtenue par l'agencement de plusieurs cellules élémentaires 101 se distingue de la matrice 10 de la figure 2B en ce que les boîtes de stockage sont prises entre, non plus deux, mais quatre sites de blocage dans la première direction et dans la deuxième direction. En d'autres termes, il y a deux sites de blocage de part et d'autre d'une même boîte de stockage. Cela permet une meilleure isolation des qubits stockés dans les boîtes de stockage lors des opérations de commande en ligne ou en colonne.

En permettant la désélection de certain(s) qubit(s) avant une opération, l'invention permet également de compenser la variabilité des qubits.

Dans les figures 2A, 2B, 3A et 3B, les grilles de commande sont représentées perpendiculaires l'une par rapport à l'autre, les directions X et Y étant perpendiculaires, mais d'autres configurations sont possibles. Alternativement, les directions X et Y ne sont pas perpendiculaires.

En outre, dans des modes de réalisation, une matrice peut comprendre des boîtes quantiques adjacentes également selon plus de deux directions dans le plan et/ou les qubits peuvent être déplacés selon plus de deux directions dans le plan, par exemple selon une troisième direction en plus des première et deuxième directions. Les boîtes quantiques et les sites de blocage sont alors astucieusement agencés pour réaliser les opérations souhaitées entre des qubits de la matrice dans chacune des trois directions du plan. Une matrice de boîtes quantiques peut notamment avoir un maillage hexagonal.

Les figures 2A, 2B, 3A et 3B, ainsi que la figure 4A décrite ci-après, représentent un état dit "inactif" dans lequel les grilles de commande n'ont pas agi sur les boîtes quantiques et donc n'ont pas déplacé les qubits. Dans l'état inactif représenté, les qubits de spin 150 sont disposés dans les premières boîtes quantiques. Alternativement, les qubits de spin peuvent être dans une des boîtes de stockage à l'état inactif.

Les figures 4A à 4H représentent des exemples de procédés de déplacement de qubits au sein d'une matrice de boîtes quantiques telle que celle représentée en figure 2B.

Comme indiqué ci-dessus, la figure 4A représente un état dit "inactif" correspondant à la figure 2A dans lequel les grilles de commande n'ont pas agi sur les boîtes quantiques et donc n'ont pas déplacé les qubits, et dans lequel les qubits de spin 150 sont disposés dans les premières boîtes quantiques. En outre, on a représenté au-dessus de la matrice une courbe représentant schématiquement pour trois boîtes quantiques les niveau B des barrière tunnel entre deux boîtes quantiques adjacentes et les potentiels chimiques P de ces trois boîtes quantiques, ainsi que le qubit confiné 150 dans la première boîte quantique 111.

La figure 4B représente une opération, partant de l'état de la figure 4A, dans laquelle on agit sur les barrières tunnel entre des colonnes adjacentes de boîtes quantiques. Plus précisément, certaines grilles 125 en colonne sont activées afin d'abaisser les barrières tunnel entre les boîtes quantiques situées de part et d'autre desdites grilles. Ceci permet de commander le déplacement de colonnes de qubits dans la première direction X. Parallèlement, d'autres grilles 126 en colonne, adjacentes aux grilles 125, peuvent être activées pour remonter la barrière tunnel et s'assurer que les qubits soient bien déplacés seulement là où les barrières tunnel sont abaissées.

On peut voir sur la courbe au-dessus des trois boîtes quantiques en figure 4B que les niveaux B des barrières tunnel entre les boîtes quantiques adjacentes ont été modifiés, plus précisément qu'ils ont été abaissés par les grilles 125 et remontés par les grilles 126. Ceci induit une augmentation du potentiel chimique P de la boîte quantique où le qubit était initialement confiné. En outre, on voit que le qubit 150 est déplacé vers la boîte quantique adjacente se situant de l'autre côté de la barrière tunnel abaissée.

Ainsi cette opération a permis de déplacer plusieurs colonnes de qubits de l'autre côté des barrières tunnel abaissées. Ces qubits déplacés sont stockés dans des boîtes quantiques de stockage à partir desquelles ils ne peuvent plus se déplacer dans la deuxième direction Y. Une seule colonne de qubits n'a pas été activée.

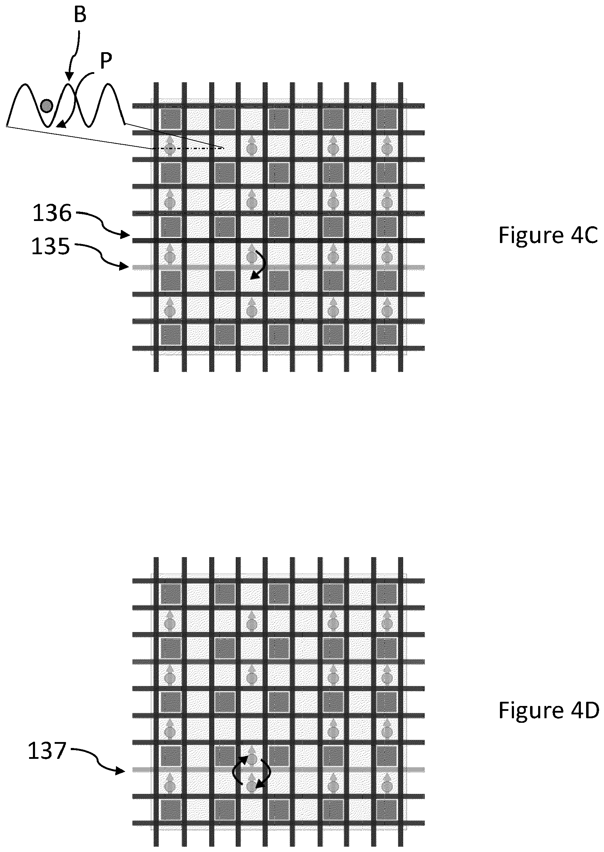

On peut voir sur la courbe au-dessus de la matrice représentée en figure 4C que les niveaux B des barrières tunnel entre les boîtes quantiques adjacentes et les niveaux P des potentiels chimiques des boîtes quantiques sont similaires à ceux de la figure 4A, à ceci près que le qubit 150 a été déplacé dans une boîte quantique adjacente à la première boîte quantique.

La figure 4C représente une opération consécutive à celle de la figure 4B, dans laquelle on actionne une grille 135 en ligne afin d'agir sur les barrières tunnel entre deux lignes adjacentes de boîtes quantiques situées de part et d'autre de la grille 135. Ceci permet de commander le déplacement d'une ligne de qubits dans la deuxième direction Y. Parallèlement, une autre grille 136 en ligne, adjacente à la grille 135, peut être activée pour remonter la barrière tunnel et s'assurer que les qubits soient bien déplacés seulement là où les barrières tunnel sont abaissées. Comme les qubits stockés dans les boîtes de stockage sont bloqués par les sites de blocage, cette opération a permis de ne déplacer que les qubits non stockés de la ligne activée, en l'occurrence un seul qubit dans l'exemple représenté.

Comme on peut le voir dans la figure 4D, on a ainsi permis le couplage d'une paire de qubits ainsi rapprochés et isolés des autres qubits, en actionnant une autre grille 137 en ligne, pour abaisser la barrière tunnel entre les boîtes quantiques contenant la paire de qubits ainsi rapprochés.

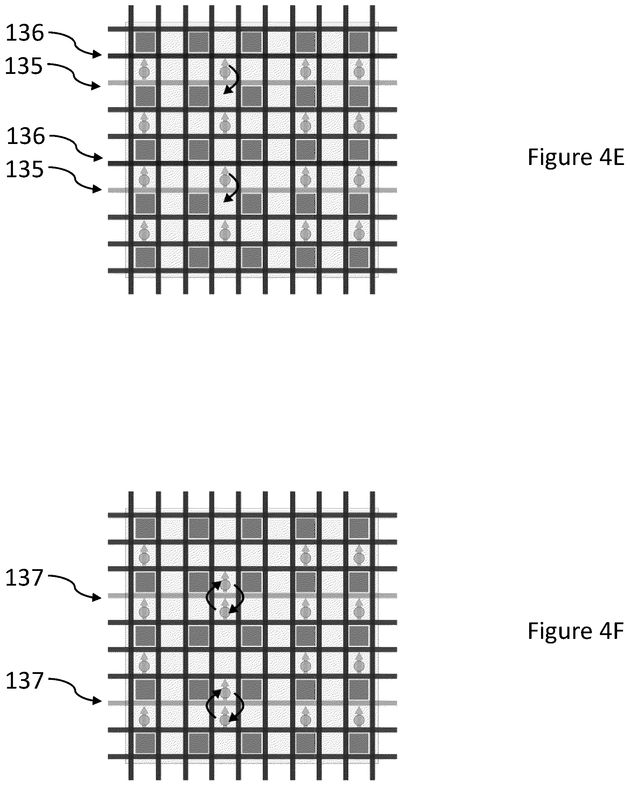

La figure 4E représente une opération alternative à celle de la figure 4C dans lequel on actionne non plus une seule, mais plusieurs grilles 135 en ligne (en l'occurrence deux grilles dans l'exemple représenté) afin d'agir sur les barrières tunnel entre des boîtes quantiques disposées de part et d'autre desdites grilles. Ceci permet de commander le déplacement d'une ligne de qubits dans la deuxième direction Y. Parallèlement, deux autres grilles 136 en ligne, adjacentes aux grilles 135, peuvent être activées pour remonter la barrière tunnel et s'assurer que les qubits soient bien déplacés seulement là où les barrières tunnel sont abaissées. Comme les qubits stockés dans les boîtes de stockage sont bloqués par les sites de blocage, cette opération a permis de ne déplacer que les qubits non stockés des lignes activées, en l'occurrence deux qubits dans l'exemple représenté.

Comme on peut le voir dans la figure 4F, on a ainsi permis le couplage de deux paires de qubits ainsi rapprochés et isolés des autres qubits, en actionnant deux autres grilles 137 en ligne, pour abaisser la barrière tunnel entre les boîtes quantiques contenant les deux paires de qubits ainsi rapprochés.

Avantageusement, la variabilité locale peut être compensée en ajustant le temps d'interaction (notamment la durée d'abaissement de la barrière tunnel) ou la valeur de tension appliquée à une grille de commande dans le cas, comme celui représenté en figures 4D et 4F, où une seule paire de qubits de spin est sélectionnée par ligne de commande (ou par colonne de commande dans d'autres cas).

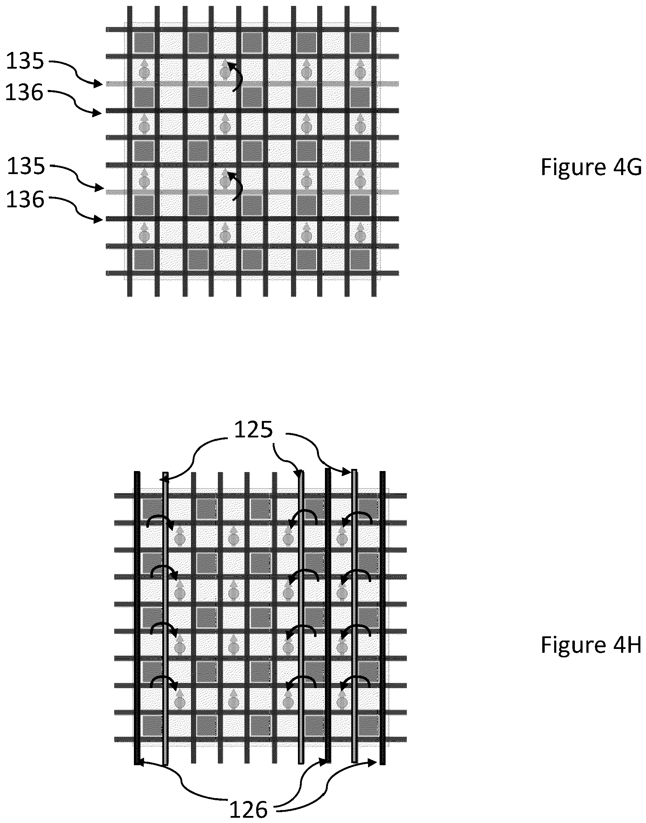

Les figures 4G et 4H montrent, partant de la configuration de la figure 4F, les opérations inverses qui sont réalisées pour retrouver l'état inactif de la figure 4A. Dans la figure 4G, des grilles 135 en ligne sont activées pour abaisser les barrières tunnel et des grilles 136 en ligne adjacentes aux grilles 135 peuvent être activées pour remonter les barrières tunnel, de sorte que les qubits reviennent dans leurs lignes initiales. Ensuite, comme représenté dans la figure 4H, des grilles 125 en colonne sont activées pour abaisser les barrières tunnel et des grilles 126 en colonne adjacentes aux grilles 125 peuvent être activées pour remonter les barrières tunnel, de sorte que les qubits reviennent dans leurs colonnes initiales.

Ces exemples d'opérations, qui ne sont en rien limitatifs, permettent de montrer le principe de déplacement de qubits mettant en œuvre une matrice de boîtes quantiques selon un mode de réalisation, et ce, afin de rapprocher des qubits entre eux et de réaliser des opérations entre lesdits qubits. Evidemment, d'autres opérations sont possibles, et toute personne du métier saura adapter le procédé de déplacement pour les opérations qu'elle souhaite réaliser et saura également adapter les opérations à toute configuration de matrice de boîtes quantiques considérée.

Par exemple, les opérations précédemment décrites peuvent être adaptés à la matrice 11 de la figure 3B. Par exemple, pour rapprocher deux qubits initialement dans les premières boîtes quantiques comme représenté en figure 3B, au moins deux opérations de déplacement sont nécessaires, au lieu d'une, mais les qubits stockés sont mieux isolés.

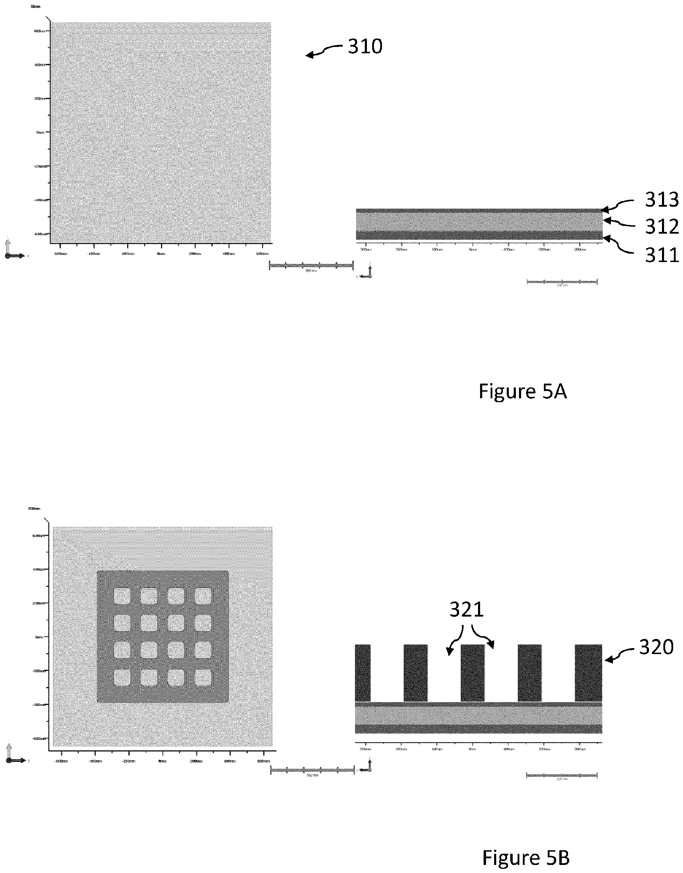

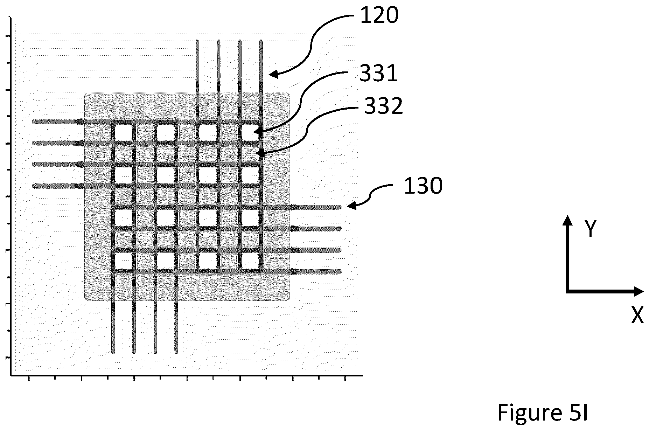

Les figures 5A à 5I représentent un exemple de procédé de fabrication d'une matrice de boîtes quantiques telle que celle représentée en figure 2B. Les figures 5A à 5H représentent une vue de dessus et une vue en coupe d'une matrice obtenue à l'issue d'une même étape ; la figure 5I représente une vue de dessus de la matrice obtenue à l'issue de la dernière étape.

La matrice peut être réalisée à partir d'un substrat SOI (Silicon On Insulator) 310 comportant une couche massive de semiconducteur 311, par exemple de silicium, sous une couche diélectrique enterrée 312, par exemple de SiO₂, sous une couche superficielle de semiconducteur 313, par exemple de silicium (figure 5A).

Alternativement, le substrat peut être une hétérostructure, par exemple un substrat comprenant une couche ou plusieurs couches en SiGe, ou tout autre substrat adapté. Il est avantageux que le substrat ait une couche supérieure en semiconducteur et une couche en matériau diélectrique sous la couche en semiconducteur.

Ensuite, une première étape de lithographie est réalisée, comprenant une sous-étape de dépôt d'une résine sensible à la radiation lumineuse, ou photorésine 320, sur la surface supérieure du substrat 310, soit dans l'exemple considéré sur la couche superficielle de semiconducteur 313, et une sous-étape de radiation lumineuse de la photorésine 320 via un masque (non représenté) formé de zones opaques bloquant les rayonnements et de zones transparentes laissant passer les rayonnements, permettant ainsi de définir un motif de photorésine 320 tel que représenté en figure 5B. Les trous 321 au sein du motif permettront de définir les sites de blocage des qubits de la matrice de boîtes quantiques.

Avantageusement, une couche d'oxyde (non représentée) peut être formée sur la surface supérieure du substrat 310, préalablement à l'étape de dépôt de la photorésine 320 sur ladite surface supérieure du substrat, afin d'éviter le contact de la photorésine avec le semiconducteur, par exemple le silicium, dans lequel seront formées les boîtes quantiques. Dans ce cas, cette couche d'oxyde doit être retirée après retrait de la photorésine.

Alternativement à une technique de photolithographie à un seul niveau comme décrite précédemment, plusieurs niveaux de photolithographie peuvent être mis en œuvre, avec transfert de motifs intermédiaires dans un masque dur préalablement déposé, selon les dimensions visées et les formes de trous recherchées, notamment lorsqu'on vise un maillage dense de trous. Par exemple, une technique de multiple-paterning, notamment de double-paterning, peut être mise en œuvre.

Ensuite, une première étape de gravure vient graver la couche superficielle de semiconducteur 313 aux endroits où la photorésine n'est pas présente, notamment dans les trous 321 au sein du motif. La photorésine 320 est ensuite enlevée, par exemple par dissolution chimique ou par oxydation.

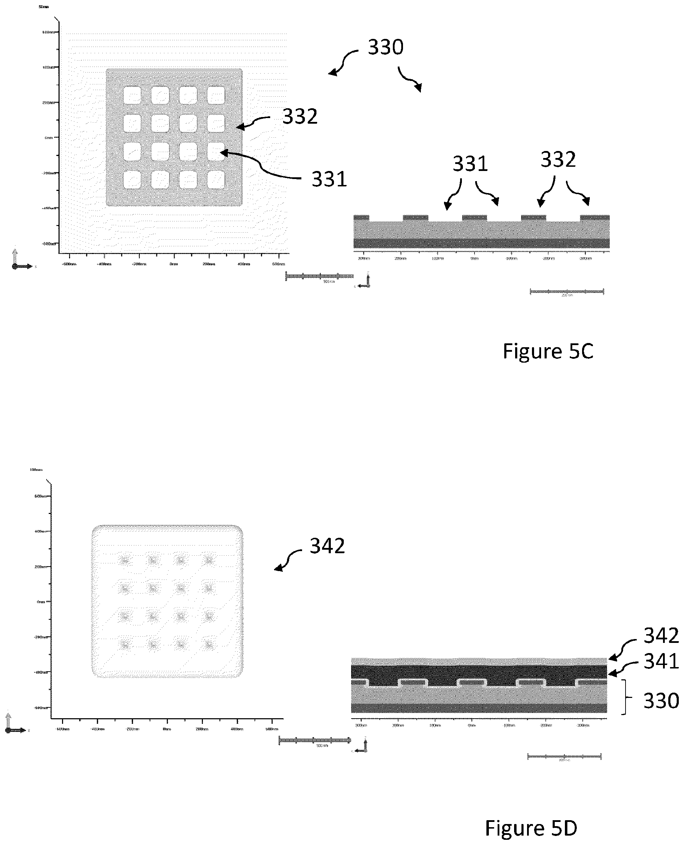

La structure obtenue 330 comprend (figure 5C) :
- des sites en diélectrique 331, par exemple en SiO₂, dans les zones (notamment dans les trous 321) où la photorésine était absente, le semiconducteur ayant été gravé jusqu'à la couche de diélectrique 312 ; et
- des sites en semiconducteur 332, par exemple en Si, dans les zones où la photorésine était présente, le semiconducteur de la couche superficielle de semiconducteur 313 étant conservé.

Tout ou partie des sites en diélectrique 331 définissent les sites de blocage des qubits de la matrice de boîtes quantiques, tandis que tout ou partie des sites en semiconducteur 332 définissent les sites dans lesquels sont formées les boîtes quantiques ainsi que les barrières tunnel de la matrice de boîtes quantiques.

Deux niveaux de grilles de commande 120, 130 sont ensuite réalisés par la mise en œuvre de plusieurs étapes de dépôt, photolithographie et gravure de matériaux conducteurs (par exemple du polysilicium (Poly-Si) et/ou des matériaux de grille métallique tels que du nitrure de titane (TiN)), et d'une étape de dépôt intermédiaire (entre les deux niveaux de grilles) d'un matériau diélectrique pour former une couche de diélectrique entre les matériaux conducteurs formant les deux niveaux de grille, et de manière optionnelle une étape de planarisation du (des) matériau(x) du deuxième niveau de grille.

Ainsi, une première étape de dépôt d'une couche de matériau conducteur 341 (par exemple TiN et/ou Poly-Si) est réalisée sur la structure 330, suivie d'une première étape de dépôt d'un masque dur 342 (figure 5D).

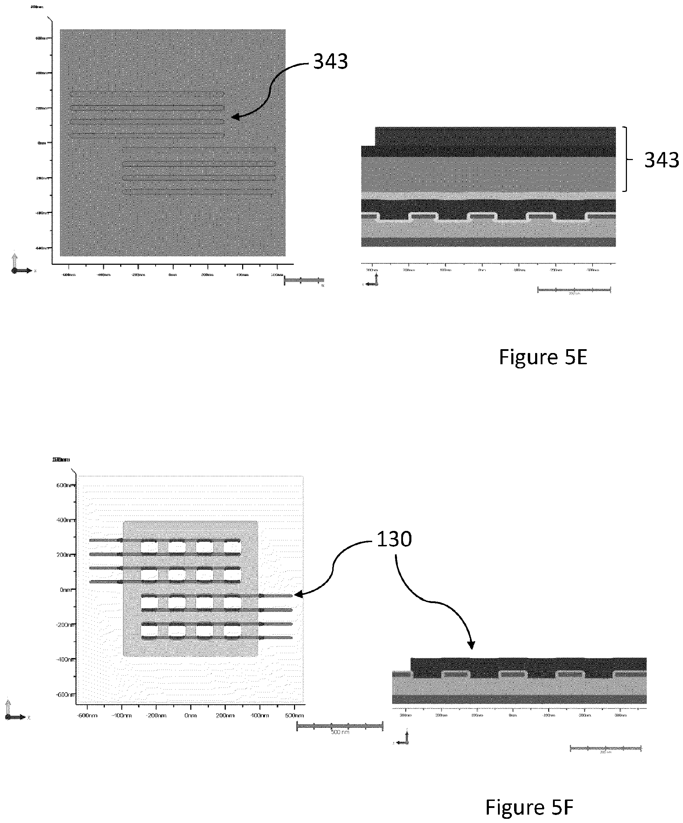

Ensuite, une deuxième étape de photolithographie est réalisée, comprenant une sous-étape de dépôt d'une photorésine 343 (ou d'un empilement de couches dont au moins une photorésine en partie supérieure) sur le masque dur 342, et une sous-étape de radiation lumineuse, via un masque (non représenté) formé de zones opaques et de zones transparentes permettant de définir un motif de photorésine 343 tel que celui représenté en figure 5E. Le motif représenté est formé de plusieurs lignes qui permettront de définir les grilles de commande en lignes 130.

Ensuite, une deuxième étape de gravure vient graver le masque dur 342 et la couche de matériau conducteur 341 aux endroits où la photorésine 343 n'est pas présente, laissant seulement des lignes de matériau conducteur définissant les grilles de commande en lignes 130 lorsque la photorésine 343, et éventuellement le masque dur 342, sont enlevés, par exemple par dissolution chimique et/ou par oxydation (figure 5F). Dans la figure 5F, on voit que le masque dur 342 a été enlevé mais ce n'est pas obligatoire, il peut être conservé afin de simplifier le procédé.

Puis une étape de dépôt d'une couche intermédiaire d'isolation 350 (en un matériau diélectrique) est réalisée afin de former une couche d'isolation entre le matériau conducteur des grilles de commande en lignes 130 et le matériau conducteur des grilles de commande en colonnes 120 qui sont formées dans les étapes suivantes.

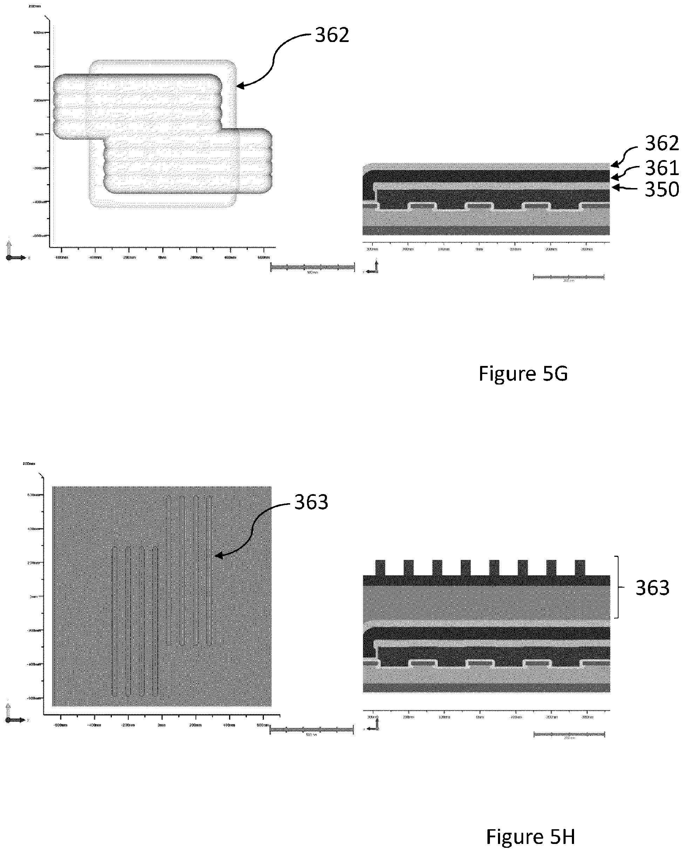

Ensuite, une deuxième étape de dépôt d'une couche de matériau conducteur 361 (par exemple TiN et/ou Poly-Si) est réalisée sur la couche intermédiaire d'isolation 350, suivie d'une deuxième étape de dépôt d'un masque dur 362 (figure 5G) .

Ensuite, une troisième étape de photolithographie est réalisée, comprenant une sous-étape de dépôt d'une photorésine 363 (ou d'un empilement de couches dont au moins une photorésine en partie supérieure) sur le masque dur 362, et une sous-étape de radiation lumineuse, via un masque (non représenté) formé de zones opaques et de zones transparentes permettant de définir un motif de photorésine 363 tel que celui représenté en figure 5H. Le motif représenté est formé de plusieurs colonnes qui permettront de définir les grilles de commande en colonnes 120.

Ensuite, une troisième étape de gravure vient graver le masque dur 362 et la couche de matériau conducteur 361 aux endroits où la photorésine 363 n'est pas présente, laissant seulement des colonnes de matériau conducteur définissant les grilles de commande en colonnes 120 lorsque la photorésine 363, et éventuellement le masque dur 362, sont enlevés, par exemple par dissolution chimique et/ou par oxydation (figure 5I).

Ainsi, la structure représentée dans la figure 5I peut former une matrice de boîtes quantiques telle que celle de la figure 2B comprenant :
- des sites en semiconducteur 332 définissant les sites dans lesquels sont formées les boîtes quantiques ainsi que les barrières tunnel de la matrice de boîtes quantiques ;
- des sites sans semiconducteur (en matériau diélectrique) 331 définissant les sites de blocage des qubits de la matrice de boîtes quantiques ;
- des grilles de commande en lignes 130 au-dessus des sites ;
- des grilles de commande en colonnes 120 au-dessus des grilles de commande en lignes 130.

Evidemment d'autres procédés et/ou configurations sont possibles. Par exemple, on peut disposer les grilles de commande en lignes 130 au-dessus des grilles de commande en colonnes 120 en inversant l'ordre des étapes correspondantes.

Pour former des boîtes quantiques, on peut utiliser les techniques connues de la personne du métier. Notamment, la réalisation de réservoirs de porteurs de charge dans des portions de la couche de semiconducteur, la réalisation des interconnexions entre les boîtes quantiques et les grilles de commande, optionnellement la formation d'espaceurs et de siliciure sur des contacts électriques, les reprises de contacts électriques, les routages de signaux peuvent être définis par des techniques connues de la personne du métier.

Pour obtenir la matrice de la figure 3B, la personne du métier saura adapter le procédé décrit ci-dessus. Notamment il saura adapter le motif de la photorésine lors de la première étape de photolithographie, et adapter la première étape de gravure afin notamment de former des sites de blocage adjacents.

En outre, on peut prévoir l'une ou plusieurs des options suivantes :
- une ou plusieurs grilles de commande supplémentaires destinées à agir sur le potentiel chimique de tout ou partie des boîtes quantiques ; et/ou
- au moins une grille de commande globale supérieure (au-dessus de la matrice) et/ou une grille de commande globale inférieure (en dessous de la matrice), une telle grille de commande globale étant destinée à faciliter le contrôle de l'ensemble de la matrice.

Avantageusement, une étape de planarisation du dernier niveau de grilles réalisé, dans l'exemple l'empilement de grilles de commande en colonne 120 peut être prévue. Ceci permet de faciliter la définition du deuxième niveau de grille lors de l'étape de gravure, la planarisation facilitant la gestion de la topographie induite par le premier niveau de grille.

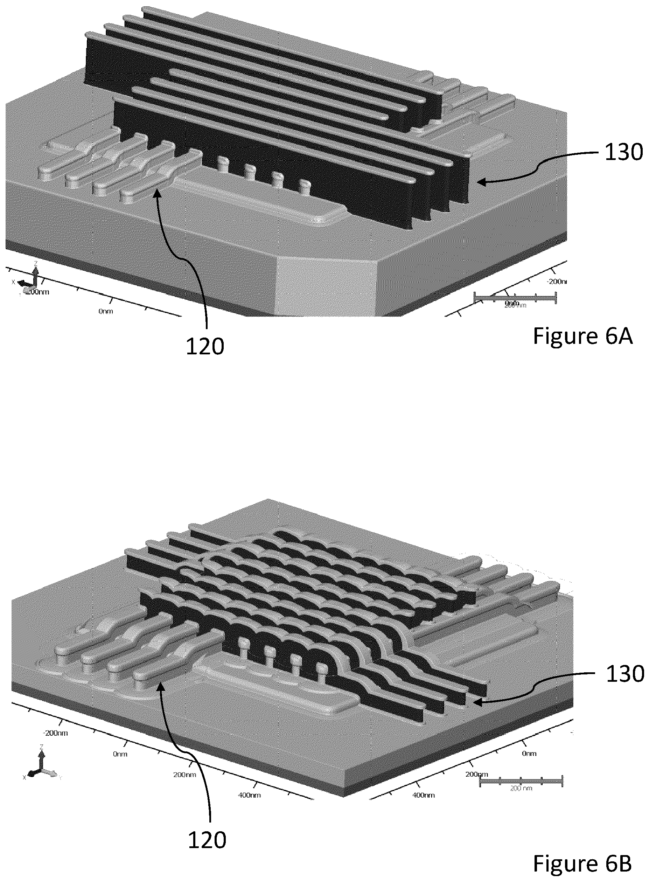

On a représenté en figure 6A une première variante d'un procédé de fabrication d'une matrice de boîtes quantiques comprenant une telle étape de planarisation. On a représenté en figure 6B une deuxième variante d'un procédé de fabrication d'une matrice de boîtes quantiques ne comportant pas d'étape de planarisation dans lequel on constate que le deuxième niveau de grilles subit la topographie du premier niveau de grilles.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, alternativement à une matrice de boîtes quantiques à maillage (ou pavage) carré, on peut envisager une matrice de boîtes quantiques à maillage (ou pavage) hexagonal avec des sites de blocage astucieusement agencées entre les boîtes quantiques.

Enfin, la mise en oeuvre pratique des modes de réalisation et variantes décrits est à la portée de la personne du métier à partir des indications fonctionnelles données ci-dessus.

## Revendications

1. Dispositif quantique sous la forme d'une matrice dimensionnelle (10, 11) de boîtes quantiques, la matrice comprenant au moins deux cellules élémentaires (100, 101) s'étendant selon un plan principal (XY) et disposées les unes à côté des autres selon une première direction (X) du plan principal et/ou une deuxième direction (Y) du plan principal, chaque cellule élémentaire (100, 101) comprenant :
- une pluralité de sites occupés par des boîtes quantiques (110) aptes à confiner au moins un qubit de spin (150) et comprenant au moins une première boîte quantique (111), une deuxième boîte quantique (112) adjacente à la première boîte quantique selon la première direction (X) du plan principal (XY) et une troisième boîte quantique (113) adjacente à la première boîte quantique selon la deuxième direction (Y) du plan principal (XY) ; et
- au moins un site de blocage ne pouvant confiner aucun qubit de spin dont un premier site de blocage (141) adjacent aux deuxième et troisième boîtes quantiques (112, 113) ; la matrice comportant ainsi une pluralité de premières, deuxièmes et troisièmes boîtes quantiques et de sites de blocage agencés pour que tout ou partie des deuxièmes boîtes quantiques (112) soient disposées entre au moins deux sites de blocage (141) dans la deuxième direction (Y), et tout ou partie des troisièmes boîtes quantiques (113) soient disposées entre au moins deux sites de blocage (141) dans la première direction (X).

2. Dispositif quantique selon la revendication 1, dans lequel chaque cellule élémentaire (100, 101) comprend en outre :
- une première grille de commande (121) s'étendant selon la deuxième direction (Y) et sur un premier niveau (120), ladite première grille de commande étant apte à envoyer un signal de commande de déplacement de qubit dans la première direction (X) en agissant sur la barrière tunnel séparant les première et deuxième boîtes quantiques ;
- une deuxième grille de commande (131) s'étendant selon la première direction (X) et sur un deuxième niveau (130) superposé au premier niveau (120), ladite deuxième grille de commande étant apte à envoyer un signal de commande de déplacement de qubit dans la deuxième direction (Y) en agissant sur la barrière tunnel séparant les première et troisième boîtes quantiques.

3. Dispositif quantique selon la revendication 2, dans lequel les cellules élémentaires adjacentes selon la deuxième direction (Y) partagent la même première grille de commande (121) et/ou les cellules élémentaires adjacentes selon la première direction (X) partagent la même deuxième grille de commande (131).

4. Dispositif quantique selon l'une des revendications 1 à 3, dans lequel pour chaque cellule élémentaire (101) :
- les boîtes quantiques comprennent en outre une quatrième boîte quantique (114) adjacente à la première boîte quantique (111) selon la première direction (X) à l'opposé de la deuxième boîte quantique (112) ;
- le au moins un site de blocage comprend en outre un deuxième site de blocage (142) adjacent aux troisième et quatrième boîtes quantiques ;
la matrice comportant ainsi également une pluralité de quatrièmes boîtes quantiques (114), les boîtes quantiques et les sites de blocage étant agencés pour que tout ou partie des quatrièmes boîtes quantiques (114) soient disposées entre au moins deux sites de blocage (142) dans la deuxième direction (Y).

5. Dispositif quantique selon la revendication 4 en combinaison avec la revendication 2 ou 3, dans lequel chaque cellule élémentaire comprend en outre :
- une troisième grille de commande (122) s'étendant sur le premier niveau (120) parallèlement à la première grille de commande (121), ladite troisième grille de commande étant apte à envoyer un signal de commande de déplacement de qubit dans la première direction (X) en agissant sur la barrière tunnel séparant les première et quatrième boîtes quantiques.

6. Dispositif quantique selon la revendication 4 ou 5, dans lequel, pour chaque cellule élémentaire (101) :
- les boîtes quantiques comprennent en outre une cinquième boîte quantique (115) adjacente à la première boîte quantique (111) selon la deuxième direction (Y) à l'opposé de la troisième boîte quantique (113) ;
- le au moins un site de blocage comprend en outre un troisième site de blocage (143) adjacent aux deuxième et cinquième boîtes quantiques et un quatrième site de blocage (144) adjacent aux quatrième et cinquième boîtes quantiques ;
la matrice comportant ainsi également une pluralité de cinquièmes boîtes quantiques (115), les boîtes quantiques et les sites de blocage étant agencés pour que tout ou partie des deuxièmes boîtes quantiques (112) soient disposées entre au moins quatre sites de blocage (141, 143) dans la deuxième direction (Y), tout ou partie des troisièmes boîtes quantiques (113) soient disposées entre au moins quatre sites de blocage (141, 142) dans la première direction (X), tout ou partie des quatrièmes boîtes quantiques (114) soient disposées entre au moins quatre sites de blocage (142, 144) dans la deuxième direction (Y), et tout ou partie des cinquièmes boîtes quantiques (115) soient disposées entre au moins quatre sites de blocage (143, 144) dans la première direction (X).

7. Dispositif quantique selon la revendication 6 en combinaison avec la revendication 5, dans lequel chaque cellule élémentaire (101) comprend en outre :
- une quatrième grille de commande (132) s'étendant sur le deuxième niveau (130) parallèlement à la deuxième grille de commande (131), ladite quatrième grille de commande étant apte à envoyer un signal de commande de déplacement de qubit dans la deuxième direction (Y) en agissant sur la barrière tunnel séparant les première et cinquième boîtes quantiques.

8. Dispositif quantique selon la revendication 7, dans lequel les cellules élémentaires adjacentes selon la deuxième direction (Y) partagent les mêmes première et troisième grilles de commande (121, 122) et/ou les cellules élémentaires adjacentes selon la première direction (X) partagent les mêmes deuxième et quatrième grilles de commande (131, 132).

9. Dispositif quantique selon l'une des revendications 1 à 8, dans lequel la matrice comprend :
- entre deux cellules élémentaires adjacentes selon la première direction (X), une cinquième grille de commande (123) s'étendant sur le premier niveau (120) parallèlement à la première grille de commande (121) ; et/ou
- entre deux cellules élémentaires adjacentes selon la deuxième direction (Y), une sixième grille de commande (133) s'étendant sur le deuxième niveau (130) parallèlement à la deuxième grille de commande (131).

10. Dispositif quantique selon l'une des revendications 1 à 9, dans lequel chaque boîte quantique est une nanostructure en semiconducteur, et chaque site de blocage est une nanostructure au moins partiellement exempte de semiconducteur, par exemple comprenant un matériau diélectrique.

11. Dispositif quantique selon l'une des revendications 1 à 10, dans lequel les bords des boîtes quantiques sont reliés à une grille de commande, et/ou les bords de certains parmi les sites de blocage, par exemple des sites de blocage sur les bords de la matrice ne sont pas tous reliés à une grille de commande.

12. Procédé de déplacement de qubits (150) dans une matrice (10, 11) d'un dispositif quantique selon l'une des revendications 1 à 11, le procédé de déplacement comprenant :
- une étape d'application d'un signal de déplacement de qubit dans la première direction (X), ledit signal étant appliqué à un alignement, selon la deuxième direction (Y), de boîtes quantiques comprenant au moins des première et troisième boîtes quantiques, le signal de déplacement permettant le déplacement d'un qubit (150) dans la première direction depuis la première boîte quantique (111) vers une deuxième boîte quantique (112) adjacente à la première boîte quantique, alors que le déplacement d'un qubit depuis la troisième boîte quantique (113) dans la première direction est bloqué par un site de blocage (141).

13. Procédé de déplacement selon la revendication 12, comprenant en outre :
- préalablement à l'étape d'application du signal de déplacement, une étape de déplacement dans la deuxième direction (Y) d'au moins un qubit (150) depuis une première boîte quantique (111) vers une troisième boîte quantique (113) adjacente à ladite première boîte quantique de manière à bloquer le déplacement dans la première direction (X) dudit qubit par le site de blocage (141).

14. Procédé de fabrication d'une matrice d'un dispositif quantique selon l'une des revendications 1 à 11, ledit procédé de fabrication comprenant :
- une étape de fourniture d'un substrat (310) ayant au moins une couche supérieure en matériau semiconducteur (313) ;
- une étape de formation de sites de blocage et de boîtes quantiques, ladite étape de formation comprenant la suppression du matériau semiconducteur dans des premières zones de la couche supérieure de semiconducteur (313) afin de former une pluralité de sites de blocage (141), des deuxièmes zones de la couche supérieure de semiconducteur (313) dans lesquelles le matériau semiconducteur n'est pas supprimé formant une pluralité de premières, deuxièmes et troisièmes boîtes quantiques (111, 112, 113) ; ladite étape de formation étant réalisée de telle sorte que chaque deuxième boîte quantique (112) soit adjacente à une première boîte quantique (111) selon une première direction (X) du plan principal (XY), que chaque troisième boîte quantique (113) soit adjacente à une première boîte quantique (111) selon une deuxième direction (Y) du plan principal (XY) et que chaque site de blocage (141) soit adjacent à une deuxième boîte quantique (112) et une troisième boîte quantique (113).

15. Procédé de fabrication selon la revendication 14, comprenant en outre :
- une étape de formation d'un premier niveau de grilles de commande (130) s'étendant parallèlement les unes aux autres dans la deuxième direction (Y) ; et
- une étape de formation d'un deuxième niveau de grilles de commande (120) s'étendant parallèlement les unes aux autres dans la première direction (X) ; chaque étape de formation du premier et du deuxième niveau de grilles de commande comprenant une étape de dépôt d'une couche en matériau conducteur, suivie d'une étape de photolithographie puis une étape de gravure.
